Europäisches Patentamt

European Patent Office

Office européen des brevets

(11) Publication number: **0 161 760**
A1

# EUROPEAN PATENT APPLICATION

(21) Application number: 85302049.3

(22) Date of filing: 25.03.85

(51) Int. Cl.⁴: **G 01 C 15/00,** G 01 D 5/20,
A 63 F 7/26, H 03 K 7/08

(30) Priority: 26.03.84 JP 41832/84 U

(43) Date of publication of application: 21.11.85
**Bulletin 85/47**

(84) Designated Contracting States: DE FR GB IT

(71) Applicant: **KABUSHIKI KAISHA UNIVERSAL, 561, Oaza
Arai, Oyama-shi Tochigi-ken (JP)**

(72) Inventor: **Kimura, Yutaka, c/o K. K. Mizuho
Seisakusho. 1-2-12, Tatsuminaka, Ikuno-ku Osaka-shi
Osaka-fu (JP)**

(74) Representative: **Ayers, Martyn Lewis Stanley et al, J.A.
KEMP & CO. 14 South Square Gray's Inn, London,
WC1R 5EU (GB)**

(54) **Electromechanical displacement transducer.**

(57) A transducer converts the amount of mechanical displacement of a member (1) to be detected into an electrical signal with the aid of magnetic induction. Two spaced apart, oppositely wound fixed coils (11, 12) are connected in series. Inside of the fixed coils, a movable coil (9) moves in cooperative association with the member (1) to be detected. With the movable coil (9) supplied with an ac current, the fixed coils (11, 12) produce an induction current whose amplitude varies with the relative position of the movable coil (9). A signal processing circuit generates a pulse having a duty ratio corresponding to the amplitude of the induction current. The pulse is converted into a dc current at a smoothing circuit to obtain a dc voltage corresponding to the amount of mechanical displacement.

EP 0 161 760 A1

DESCRIPTION

0161760

TITLE:   DEVICE FOR CONVERTING AMOUNT OF MECHANICAL
         DISPLACEMENT INTO ELECTRICAL SIGNAL

The present invention relates to transducers using magnetic induction for converting an amount of mechanical displacement into an electrical signal.

Transducers have been widely used for converting an amount of mechanical displacement into an electrical signal.  As for the amount of mechanical displacement, there are known in the art, for example, the amount of manipulation of an operation member which is rotated or slid by hand and the amount of movement of a movement member capable of moving or sliding.  Manipulation members of this kind include tuning or adjusting knobs of radio receivers and an operating handle for a pinball machine (one of the machines of this kind is called a Pachinko machine in Japan).  In particular, if the player turns the operating handle (operating knob), the resultant amount of angular movement of the operation handle changes the voltage across the solenoid plunger.  Since the speed of movement of the plunger varies with the value of voltage across the solenoid plunger, it is possible to control the shooting speed of a ball.  In other words, when the ball is shot aiming at a desired position on a play field, the larger the angle the operating handle is moved through, the harder the ball is fired.  Thus, the player fires the ball as hard as desired by moving the operating handle through a given angle.  Therefore, it is necessary for the transducer to have no play over the range through which the handle is moved, and to give a correct correspondence between the angle and the firing force.

Variable resistors hae been utilised for detecting the degree of movement of an operating member, but have the disadvantage that their mechanical life is relatively short. Also the conversion into an electrical signal can be effected by using various types of optical transducers. For example, with a pulse counter type transducer, in order to improve the precision of the transducer, a high precision compatible with the precision of the transducer is required for gear mechanisms or electronic circuits. As a result, the apparatus becomes expensive. Moreover, the optical system of the transducer necessitates counter-measure against foreign matters or dust. Therefore, there arises a problem that a low-priced, simple, and highly reliable transducer is hard to realise.

According to the present invention, there is provided a transducer for converting the amount of mechanical displacement of a member to be detected into an electrical signal comprising:

a first coil, in use, driven by an ac signal;

a second coil disposed adjacent to said first coil for generating an induction current by detecting the change of magnetic field produced by said first coil;

a movable member in cooperative association with said member for changing a distance between said first coil and said second coil by making said first and second coils to move relative to each other;

means for converting the amplitude of said induction current into the duty ratio of a pulse; and

means for smoothing and converting said pulse into a dc current.

In a ball shooting apparatus embodying the present invention, the transducer is in cooperative association with an operating handle, and a solenoid plunger is provided for firing a ball previously held stationary at a firing position. The dc signal output from the transducer is supplied to a driver of the solenoid plunger. The driver adjusts the voltage applied to the solenoid plunger in accordance with the input dc signal, thereby varying the force of impact of the solenoid plunger against the ball.

According to the present invention, the amount of displacement of a movable member (manipulation member) is converted into an electrical signal using magnetic induction. Thus, non-contact detection of the amount of mechanical displacement can be made, the durability is improved and the degrading of signals due to foreign matter as in optical systems does not occur. Moreover, it is possible to detect movement with a high precision with a simple construction. Further, the circuit has low-pass characteristics so that suppression of noises can be effected.

The invention will be further described by way of non-limitative example with reference to the accompanying drawings, in which:-

Figure 1 is a brief diagram showing a ball firing device of a pinball game machine incorporating a transducer according to the present invention;

Figure 2 is a circuit diagram showing one example of the signal processing circuit of Figure 1; and

Figure 3 is a graph showing signal waveforms in the signal processing circuit of Figure 2.

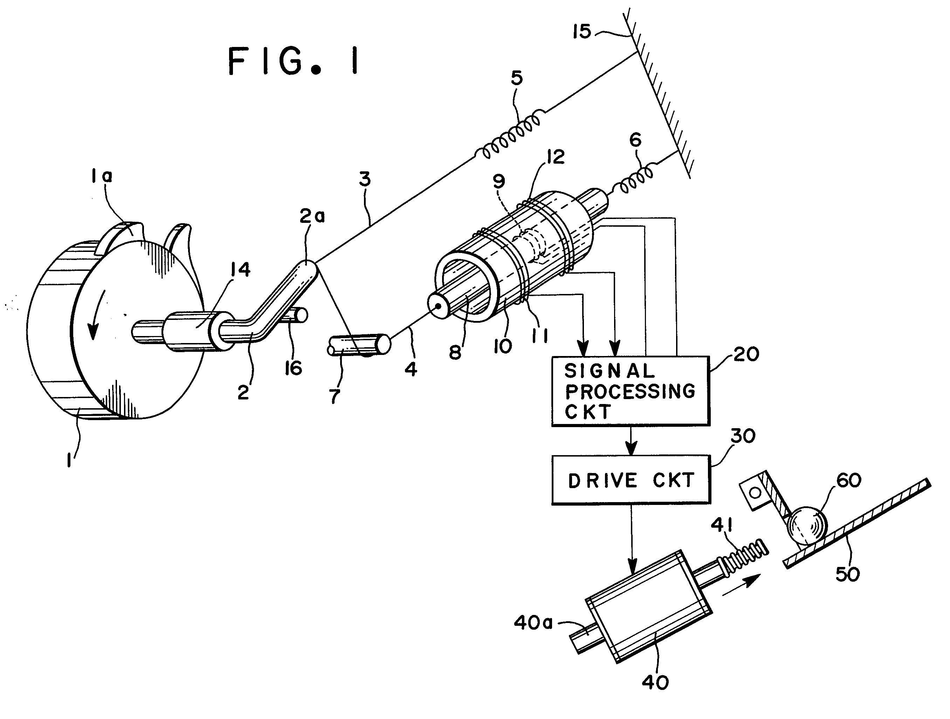

Referring to Figure 1, a pinball machine (Pachinko game machine) includes, as well known in the art, a play field (not shown) covered with transparent glass (not shown). On a panel (not shown) positioned beneath the transparent glass, an operating handle 1 is pivotally mounted. The operating handle 1 is provided with a finger holder 1a which is rotated in the arrowed direction in order to fire a ball. At the back of the operation handle 1, an L-shaped bar 2 is mounted. A bush 14 fixed to the panel is engaged with the L-shape bar 2 such that the operating handle 1 rotates together with the L-shaped bar 2.

Two wires 3 and 4 are coupled to the distal end of the L-shaped bar 2. The wire 3 is fixedly connected at its one end to a fixed base 15 through a tension spring 5 which urges the L-shaped bar 2 to abut a fixed pin 16 at a neutral position. The wire 4 is turned by a guide 7 and is coupled at its one end to one end of a movable bar 8 made of insulating material. The other end of the movable bar 8 is coupled to another tension spring 6 which pulls the movable bar 8 toward the fixed base 15 as the operation handle 1 is turned in the arrow direction.

A movable coil 9 is wound about the movable bar 8, the movable coil 8 being supplied as a driving current with an ac signal from a signal processing circuit 20. In order to detect, using magnetic induction, the magnetic field generated by the movable coil 9, fixed coils 11 and 12 are provided which are oppositely wound relative to one another and spaced apart by a preset distance. The fixed coils 11 and 12 are wound on and about a hollow circular tube 10 which is disposed concentrically with the movable bar and has an insulator nature. The fixed coils 11 and 12 are fixed on the tube 10 for example with tape, adhesive and the like. The hollow circular tube 10 is fixedly mounted on the game machine body. An ac current induced upon the fixed coils 11 and 12 is converted into a dc voltage at the signal processing circuit 20. The dc voltage is input to a drive circuit and in turn drives a solenoid plunger 40. The drive circuit 30 is constructed of a pulse generator and an amplifier for amplifying a pulse from the pulse generator. The drive circuit 30 supplies to the solenoid plunger 40 a drive pulse having an amplitude differing in accordance with the input dc voltage. The solenoid plunger 40, as well known in the art, advances the plunger 40a while the solenoid coil (not shown) is energized. On the end of the plunger 40a, a spring 41 for absorbing impact force and sound is mounted. Every time a drive pulse with a controlled amplitude is supplied, the plunger 40a advances to fire a ball 60 held stationary at a firing position. The ball 60 is guided along a guide rail 50 into the play field (not shown). The plunger 40a is returned to the original position as shown in Figure 1 by a built-in spring or the like after the ball 60 is shot.

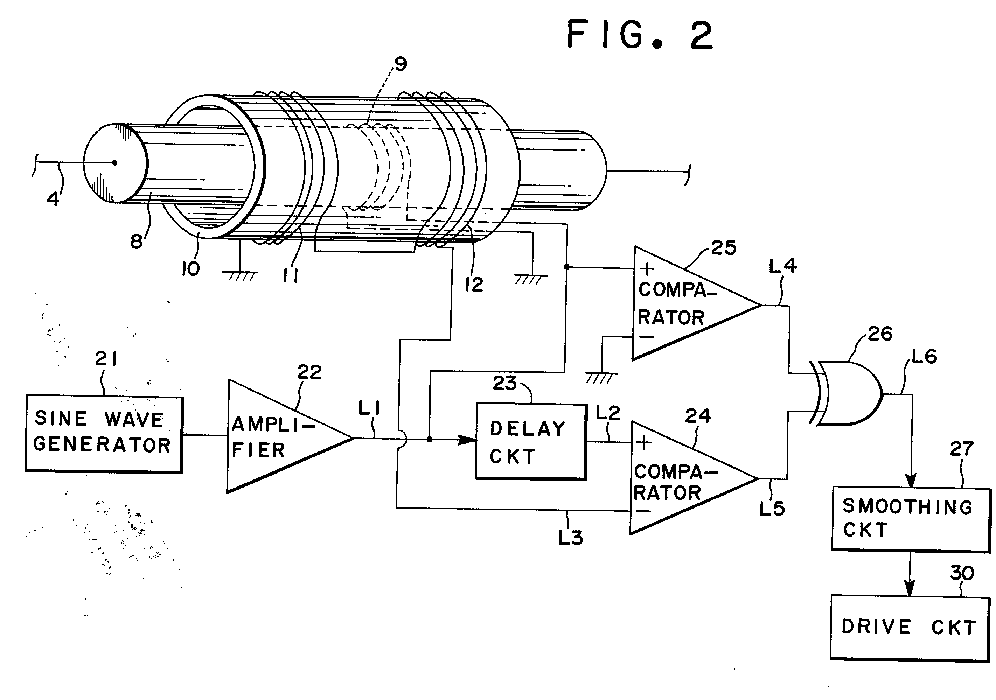

In Figure 2 particularly showing the signal processing circuit, an ac signal from a sine wave generator 21 is supplied through a drive amplifier to one end of the movable coil 9 wound about the movable bar 8, the other end being grounded. One end of the fixed coil 11 wound about the hollow circular tube 10 is connected to one end of the fixed coil 12 wound in the opposite direction to that of the fixed coil 12, the other end of the fixed coil 11 being grounded. The other end of the fixed coil 12 is connected to a negative input terminal of a comparator 24. The positive input terminal of the comparator 24 is input with a signal obtained by delaying an output from the amplifier 22 by $\pi/2$ in phase at a delay circuit 23.

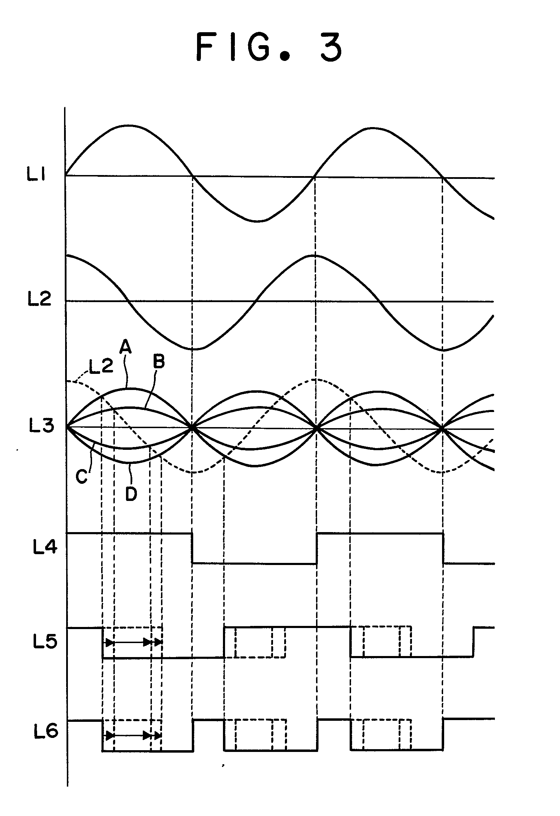

The output signal from the amplifier 22 is input to the positive input terminal of a comparator 25 of which the negative input terminal is grounded. The output terminals of both comparators 24 and 25 are connected to both input terminals of an exclusive OR gate 26. The output signal from the gate 26 is converted into a dc signal at a smoothing circuit 27, and the dc signal is input to the plunger drive circuit 30 described above. Signal waveforms in respective signal lines in the circuit diagram of Figure 2 are shown in Figure 3.

Next, the operation of the above embodiment will be described. If the operating handle 1 is not being touched, the L-shaped bar 2 abuts the fixed pin 16, and the movable coil 9 and fixed coil 12 are aligned one with the other. The signal from the sine wave generator 21 is amplified at the amplifier 22 and the obtained sine wave signal L1 is supplied to the movable coil 9 and to the comparator 25. The comparator 25 outputs a rectangular waveform signal L4 as shown in Figure 4. The sine wave signal L1 is delayed by $\pi/2$ in phase at the delay circuit 23, and in turn the delayed signal L2 is input to the positive terminal of the comparator 24. Upon delivery of the sine wave signal L1 to the movable coil 9, the waveform of an induced signal L3 on the fixed coil 12 becomes the same waveform A as of the sine wave signal L1. Therefore, a rectangular waveform signal L6 shown by the solid line is output from the gate 26.

Next, as the operating handle 1 is turned in the arrow direction, the wire 4 moves and pulls the spring 6 to thereby move the movement bar 8 in the left within the hollow circular tube 10. The movable coil 9 together with the movable bar 8 are moved to the left to approach the fixed coil 11. Since the fixed coils are oppositely wound to each other, the currents induced on the respective fixed coils 11 and 12 are cancelled out. As a result, while the movable coil is positioned intermediate of the fixed coils 11 and 12, the signal L3 becomes zero. If the movable coil 9 moves over the intermediate position and goes near to the fixed coil 11, then a waveform D opposite in phase to the waveform A is obtained. As appreciated, the signal L3 takes: 1) a waveform A while the movable coil 9 overlies the fixed coil 12; 2) a waveform B while the movable coil 9 moves toward the fixed coil 11; and 3) in succession, a waveform C and a waveform D when the movable coil 9 is aligned with the fixed coil 9.

The comparator 24 compares the signal L2 with the signal L3 to output a signal L5. The signal L5 has a phase corresponding to the position of the movable coil 9, the phase being shifted as shown by an arrow to the left as the movable coil 9 goes near to the fixed coil 11. The gate 26 detects the coincidence between the signals L4 and L5, and in turn outputs a signal L6 having a different pulse width in accordance with the phase shift of the signal L5. That is, as the movable coil goes near to the fixed coil 11, the duty ratio of the signal L6 becomes larger. The signal L6 is input to and smoothed at the smoothing circuit 27, and is converted into a dc current. The smoothing circuit 27 produces a higher dc voltage as the duty ratio becomes larger.

As described above, the angle through which the handle 1 is turned is converted into a dc voltage by means of the movable coil 9, fixed coils 11 and 12, and signal processing circuit 20. The dc voltage is applied to the known drive circuit 30 to drive the solenoid plunger 40. Therefore, the solenoid plunger 40 fires the ball 60 with an impact force corresponding to the amount of angular movement of the operation handle 1 and at predetermined intervals. The actual operation of the operation handle 1 is arranged such that a small angular movement causes the power source for the circuits turn on and a further movement causes the movable bar 8 to start moving.

In the above embodiment, a movable coil has been used as a coil 9, however, the coil 9 may be fixed and the coil 11 and 12 may be moved, by making the hollow circular tube ₁10 instead of the coil 9 movable. Obviously many modifications and variations of the present invention are possible in the light of the above teachings. It is therefore to be understood that the scope of the invention is to be determined solely by the following claims.

## CLAIMS

1. A transducer for converting the amount of mechanical displacement of a member (1) to be detected into an electrical signal comprising:

a first coil (9), in use, driven by an ac signal (L1);

a second coil (11,12) disposed adjacent to said first coil (9) for generating an induction current (L3) by detecting the change of magnetic field produced by said first coil (9);

a movable member (8) in cooperative association with said member (1) for changing a distance between said first coil (9) and said second coil (11, 12) by making said first and second coils to move relative to each other;

means (23, 24, 25, 26) for converting the amplitude of said induction current (L3) into the duty ratio of a pulse (L6); and

means (27) for smoothing and converting said pulse (L6) into a dc current.

2. A transducer according to claim 1, wherein said second coil comprises oppositely wound coils (11, 12) connected in series and spaced apart from each other by a suitable distance.

3. A transducer according to claim 2, wherein said first coil (9) is a movable coil and said second coil comprises a first fixed coil (11) and a second fixed coil (12).

4. A transducer according to claim 3, wherein said movable coil (9) is disposed at a position between said first fixed coil (11) and said second fixed coil (12).

5. A transducer according to claim 4, wherein said movable member (8) is of an insulating nature, said movable coil (9) being wound about the outer periphery of said movable member.

6. A transducer according to claim 5 further comprising a hollow circular tube (10) of an insulating nature disposed encircling said movable member (8), said first fixed coil (11) and said second fixed coil (12) being wound about the outer periphery of said hollow circular tube.

7. A transducer according any one of claims 2 to 6, wherein said means for converting into the duty ratio of the pulse comprises: a first comparator for comparing said ac signal (L1) with a reference potential; a delay circuit (23) for delaying said ac signal (L1) by $\pi/2$ in phase; a second comparator (24) for comparing an output signal (L2) from said delay circuit (23) with said induction current (L3); and an exlusive OR gate (26) for inputting the output signals from said both comparators (25, 24).

8. A transducer according to claim 7, wherein said member to be detected is an operating handle (1), said operation handle and said movable member (8) being coupled by a wire (4).

9. A games machine operatively incorporating at least one transducer according to any one of the preceding claims.

# FIG. I

SIGNAL PROCESSING CKT    20

DRIVE CKT    30

0161760

F I G. 2

SINE WAVE GENERATOR  21

AMPLI-FIER  22

DELAY CKT  23

COMPA-RATOR  24

COMPA-RATOR  25

26

SMOOTHING CKT  27

DRIVE CKT  30

L1  L2  L3  L4  L5  L6

4  8  9  10  11  12

# FIG. 3

L1

L2

L2 A B

L3

C

D

L4

L5

L6

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | US-A-3 827 291 (INT. RESEARCH AND DEVELOPMENT CO. LTD.) * The whole document * | 1,2,3, 4 | G 01 D 5/246 G 01 D 5/20 A 63 F 7/26 H 03 K 7/08 |
| A | | 5,6,7, 8 | |
| Y | DE-A-1 773 793 (K.KUPPERS) * The whole document * | 1,2,3, 4 | |
| A | | 7 | |
| A | US-A-4 189 674 (TRW INC.) * The whole document * | 1-7 | |
| A | DE-A-3 227 296 (NIPPON ELECTRIC CO.) * The whole document * | 1,7 | TECHNICAL FIELDS SEARCHED (Int. Cl.4) G 01 D 5/00 A 63 F 7/00 H 03 K 7/00 |
| A | 28th IEEE VEHICULAR TECHNOLOGY CONFERENCE, Conference Record of Papers presented at the Twenty-Eighth Annual Conference, Denver, Colorado, 22nd-24th March 1978, pages 533-536, IEEE, New York, US; E.GREENSTEIN et al.: "A multifunction integrated circuit for automotive sensors" * Pages 533-536 * | 1,7 | |

--- -/-

The present search report has been drawn up for all claims

| Place of search | Date of completion of the search | Examiner |
|---|---|---|
| THE HAGUE | 09-07-1985 | BROCK T.J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-4 390 796 (LEEDS AND NORTHRUP CO.) * The whole document * | 1,7 | |
| A | US-A-4 065 715 (GENERAL MOTORS CORP.) * The whole document * | 1,7 | |
| A | US-A-4 295 651 (TOMY KOGYO CO. INC.) * The whole document * | 1,8,9 | |
| A | FR-A-2 050 626 (C.FAROUX) * The whole document * | 1,8,9 | |

----- 

TECHNICAL FIELDS
SEARCHED (Int. Cl.4)

The present search report has been drawn up for all claims

| Place of search THE HAGUE | Date of completion of the search 09-07-1985 | Examiner BROCK T.J. |
|---|---|---|